# EUROPEAN PATENT APPLICATION

(11) **EP 4 772 343 A1**
(43) Date of publication of application: **08.07.2026**
(21) Application number: 24905598.9
(22) Date of filing: 16.08.2024
(51) Int. Cl.: B32B 27/02, B32B 27/04, B32B 27/34, B32B 27/38, H05K 5/02, H04M 1/02, H04M 1/18

(54) **MULTI-LAYER COMPOSITE STRUCTURE, PREPARATION METHOD, BATTERY COVER, AND ELECTRONIC DEVICE**

(30) Priority: 17.12.2023 CN 202311751031
(71) Applicant: Honor Device Co., Ltd., Shenzhen, Guangdong 518040 (CN)
(72) Inventor: SHEN, Kui, Shenzhen, Guangdong 518040 (CN); TAN, Dongsheng, Shenzhen, Guangdong 518040 (CN); ZHANG, Zhengchi, Shenzhen, Guangdong 518040 (CN)
(74) Representative: Gill Jennings & Every LLP
(86) International application number: PCT/CN2024/112881
(87) International publication number: WO 2025/130103

(57) **Abstract**

This application provides a multi-layer composite structure, a preparation method, a battery cover, and an electronic device. The multi-layer composite structure is formed by a plurality of stacked fiber layers. Each fiber layer is formed by impregnating a fiber sheet in a prepolymer solution followed by curing, and the fiber sheet in at least one fiber layer is made of a poly-p-phenylene benzobisoxazole fiber, i.e., a PBO fiber. In this way, the multi-layer composite structure may be endowed with higher strength and modulus. When the multi-layer composite structure is subjected to an impact, energy is absorbed and dissipated. Therefore, the reliability of the multi-layer composite structure in the impact is not compromised based on thickness and weight reduction, thereby providing excellent puncture resistance for the battery cover formed from the multi-layer composite structure.

## Description

This application claims priority to Chinese Patent Application No. 202311751031.6, filed with the China National Intellectual Property Administration on December 17, 2023 and entitled "MULTI-LAYER COMPOSITE STRUCTURE, PREPARATION METHOD, BATTERY COVER, AND ELECTRONIC DEVICE", which is incorporated herein by reference in its entirety.

### TECHNICAL FIELD

This application relates to the field of terminal technologies, and in particular, to a multi-layer composite structure, a preparation method, a battery cover, and an electronic device.

### BACKGROUND

An appearance housing for a consumer electronic device such as a mobile phone, a tablet computer, or a PC mainly serves to decorate an appearance and protect use safety of a device such as a built-in battery of the electronic device. At present, there is an intense demand for overall weight and thickness reduction as well as high reliability in consumer electronic products, especially foldable devices. In the appearance housing, a battery cover is one of the primary scenarios targeted for thickness and weight reduction.

Under the current structural design of a battery cover for a foldable device, traditional glass fiber composite materials can no longer meet the design requirements for thickness and weight reduction. Furthermore, the battery cover made of glass fiber composite materials poses high reliability risks, particularly exhibiting poor puncture resistance in the event of device drops. It is thus impossible to achieve the design of reducing the thickness and weight of the battery cover while ensuring reliable drop protection for the battery cover.

### SUMMARY

This application provides a multi-layer composite structure, a preparation method, a battery cover, and an electronic device, to address a problem that reliable drop protection cannot be provided after reducing the thickness and weight of the battery cover in the electronic device.

According to a first aspect of embodiments of the present invention, a multi-layer composite structure is provided, including: a plurality of stacked fiber layers. Each fiber layer is formed by impregnating a fiber sheet in a prepolymer solution followed by curing, where the fiber sheet in at least one fiber layer is made of a poly-p-phenylene benzobisoxazole PBO fiber. In this way, leveraging high strength and high modulus properties of the PBO fiber relative to those of a glass fiber, the multi-layer composite structure can achieve better energy absorption and dissipation performance when subjected to an impact. Therefore, the reliability of the multi-layer composite structure in the impact is not compromised based on thickness and weight reduction.

In a feasible implementation, at least one fiber layer among the plurality of fiber layers is a first fiber layer. The fiber sheet in each first fiber layer is formed by arranging PBO fiber tows in the same extension direction and under a straightened state. In this way, the density of the PBO fiber tows in the first fiber layer can be increased by unidirectionally arranging the PBO fiber tows, thereby reducing the impact of the prepolymer solution in the fiber layer on the strength and modulus of the fiber layer.

In a feasible implementation, each fiber layer among the plurality of fiber layers is the first fiber layer. The PBO fiber tows in adjacent first fiber layers are in different extension directions. In this way, the energy absorption and dissipation performance of the formed multi-layer composite structure can be improved, thereby improving a puncture resistance effect thereof.

In a feasible implementation, an angle between the extension directions of the PBO fiber tows in adjacent first fiber layers is a right angle.

In a feasible implementation, each fiber layer among the plurality of fiber layers is the first fiber layer. The PBO fiber tows in the topmost and bottommost first fiber layers in the multi-layer composite structure extend in a first direction. The PBO fiber tows in the remaining first fiber layers in the multi-layer composite structure extend in a second direction. The first direction is different from the second direction. In this way, the energy absorption and dissipation performance of the formed multi-layer composite structure can be improved, thereby improving a puncture resistance effect thereof.

In a feasible implementation, an angle between the first direction and the second direction is a right angle.

In a feasible implementation, a mass proportion of the prepolymer solution in each first fiber layer is 30% to 45%. Each first fiber layer has a thickness of 0.04 mm to 0.2 mm. In this way, when the first fiber layer is cured by using the prepolymer solution, the content of the prepolymer solution in the first fiber layer can be reduced, and the strength and modulus of the first fiber layer can be improved.

In a feasible implementation, the remaining fiber layers other than the first fiber layers in the plurality of fiber layers are third fiber layers. The fiber sheet in the third fiber layer is formed by arranging first fiber tows in the same extension direction and under a straightened state. The first fiber tows are any one fiber selected from a glass fiber, an aramid fiber, a ceramic fiber, and a carbon fiber. The plurality of third fiber layers are stacked. At least one first fiber layer is disposed between adjacent third fiber layers. In this way, the PBO fiber may be combined with another fiber, to improve a binding force between different fiber layers, thereby improving the overall strength of the multi-layer composite structure.

In a feasible implementation, the PBO fiber tows in the first fiber layers extend in a third direction. The first fiber tows in the third fiber layer adjacent to the first fiber layer extend in a fourth direction. The first fiber tows in adjacent third fiber layers are in different extension directions. The third direction is different from the fourth direction. In this way, the strength of the fiber layer can be improved by means of weaving fibers, thereby improving the puncture resistance effect of the multi-layer composite structure.

In a feasible implementation, an angle between the third direction and the fourth direction is a right angle.

In a feasible implementation, at least one fiber layer among the plurality of fiber layers is a second fiber layer. The fiber sheet in each second fiber layer is formed by weaving PBO fiber tows in which extension directions are a fifth direction and a sixth direction. The fifth direction is different from the sixth direction. In this way, the fiber layer may be formed by the fiber sheet produced via weaving, thereby preventing yarn loosening in the fiber sheet composed of the PBO fiber tows.

In a feasible implementation, each fiber layer among the plurality of fiber layers is the second fiber layer. An angle between the fifth direction and the sixth direction is a right angle.

In a feasible implementation, a mass proportion of the prepolymer solution in each second fiber layer is 45% to 55%. Each second fiber layer has a thickness of 0.1 mm to 0.2 mm.

In a feasible implementation, the remaining fiber layers other than the second fiber layers in the plurality of fiber layers are fourth fiber layers. The fiber sheet in the fourth fiber layer is formed by weaving second fiber tows in which extension directions are the fifth direction and the sixth direction. The second fiber tows are any one fiber selected from a glass fiber, an aramid fiber, a ceramic fiber, and a carbon fiber. The plurality of fourth fiber layers are stacked. At least one second fiber layer is disposed between adjacent fourth fiber layers. In this way, the PBO fiber may be combined with another fiber, to improve a binding force between different fiber layers, thereby improving the overall strength of the multi-layer composite structure.

In a feasible implementation, a mass proportion of the prepolymer solution in each fiber layer is 30% to 60%. Each fiber layer has a thickness of greater than or equal to 0.03 mm and less than or equal to 0.3 mm.

According to a second aspect of embodiments of the present invention, a preparation method for a multi-layer composite structure is provided, including: placing an epoxy resin monomer, a curing agent, an accelerator, a dispersant, and a filler in a prepreg, followed by sufficient stirring and pre-curing to obtain a prepolymer solution; impregnating fiber sheets in the prepolymer solution and performing curing treatment to obtain fiber layers; and cutting, stacking, and laminating the plurality of fiber layers to obtain a multi-layer composite structure, where the fiber sheet in at least one fiber layer is made of a PBO fiber.

In a feasible implementation, the impregnating fiber sheets in the prepolymer solution and performing curing treatment to obtain fiber layers includes: positioning fiber package yarns, and unidirectionally arranging fiber tows by means of yarn swinging to prepare the plurality of fiber sheets, where the fiber tows in at least one fiber sheet are PBO fiber tows; impregnating the plurality of fiber sheets in the prepolymer solution respectively; controlling a mass proportion of the prepolymer solution in the plurality of impregnated fiber sheets, as well as a thickness of the plurality of impregnated fiber sheets; and curing the plurality of impregnated fiber sheets respectively to obtain the plurality of fiber layers.

In a feasible implementation, the cutting, stacking, and laminating the plurality of fiber layers to obtain a multi-layer composite structure includes: cutting the plurality of fiber layers respectively to obtain a plurality of fiber layers of a preset size; stacking the plurality of cut fiber layers, where fiber tows in adjacent fiber layers are in different extension directions, or the fiber tows in the topmost and bottommost fiber layers extend in a first direction, the fiber tows in the remaining fiber layers other than the topmost layer and the bottommost layer extend in a second direction, and the first direction is different from the second direction; and laminating the plurality of stacked fiber layers to obtain the multi-layer composite structure.

In a feasible implementation, a mass proportion of the prepolymer solution in each fiber layer is 30% to 45%. Each fiber layer has a thickness of 0.04 mm to 0.2 mm.

In a feasible implementation, the impregnating fiber sheets in the prepolymer solution and performing curing treatment to obtain fiber layers includes: preparing a plurality of woven fiber sheets by weaving fiber tows, where the fiber tows in at least one woven fiber sheet are PBO fiber tows; impregnating the plurality of woven fiber sheets in the prepolymer solution respectively; controlling a mass proportion of the prepolymer solution in the plurality of impregnated woven fiber sheets, as well as a thickness of the plurality of impregnated woven fiber sheets; and curing the plurality of impregnated woven fiber sheets respectively to obtain the plurality of fiber layers.

In a feasible implementation, the cutting, stacking, and laminating the plurality of fiber layers to obtain a multi-layer composite structure includes: cutting the plurality of fiber layers respectively to obtain a plurality of fiber layers of a preset size; stacking the plurality of cut fiber layers; and laminating the plurality of stacked fiber layers to obtain the multi-layer composite structure.

In a feasible implementation, a mass proportion of the prepolymer solution in each fiber layer is 45% to 55%. Each fiber layer has a thickness of 0.1 mm to 0.2 mm.

In a possible implementation, the fiber sheet has a grammage of 30 g/m2 to 140 g/m2.

In a possible implementation, the lamination includes hot pressing, a hot pressing temperature is 100°C to 200°C, a hot pressing time is 10 min to 30 min, and a hot pressing pressure is 0.2 MPa to 0.7 MPa.

In a feasible implementation, a mass proportion of the prepolymer solution in the fiber layer is 30% to 60%. The fiber layer has a thickness of 0.03 mm to 0.3 mm.

In a feasible implementation, the cutting may adopt laser cutting.

According to a third aspect of embodiments of the present invention, a battery cover is provided, including: a substrate layer, where the substrate layer includes the multi-layer composite structure according to any one of the foregoing; a decorative layer, where the decorative layer is disposed on a side of the substrate layer, and a through hole is provided on the substrate layer and the decorative layer; and a camera lens, where the camera lens covers the through hole, and the camera lens is disposed on a side of the battery cover provided with the decorative layer.

According to a fourth aspect of embodiments of the present invention, an electronic device is provided, including: a front panel; a middle frame, where the middle frame is disposed on a side of the front panel, and a battery compartment is disposed in the middle frame; a battery, where the battery is disposed in the battery compartment; and the foregoing battery cover, where the battery cover is disposed on a side of the middle frame away from the front panel, and the battery cover is configured to protect the battery disposed in the battery compartment.

This application provides a multi-layer composite structure, a preparation method, a battery cover, and an electronic device. The multi-layer composite structure is formed by a plurality of stacked fiber layers. Each fiber layer is formed by impregnating a fiber sheet in a prepolymer solution followed by curing, and the fiber sheet in at least one fiber layer is made of a poly-p-phenylene benzobisoxazole PBO fiber. In this way, the multi-layer composite structure may be endowed with higher strength and modulus. When the multi-layer composite structure is subjected to an impact, energy is absorbed and dissipated. Therefore, the reliability of the multi-layer composite structure in the impact is not compromised based on thickness and weight reduction.

### BRIEF DESCRIPTION OF DRAWINGS

FIG. 1 is a schematic structural diagram of a battery cover;
FIG. 2 is a schematic structural diagram of a substrate layer of a battery cover;
FIG. 3 is a schematic structural diagram of another substrate layer of a battery cover;
FIG. 4 is a schematic structural diagram of still another substrate layer of a battery cover;
FIG. 5 is a schematic structural diagram of still another substrate layer of a mobile phone cover;
FIG. 6 is a schematic diagram of a multi-layer composite structure according to an embodiment of this application;
FIG. 7 is a schematic diagram of a multi-layer composite structure provided with a first fiber layer according to an embodiment of this application;
FIG. 8 is a schematic diagram of another multi-layer composite structure provided with a first fiber layer according to an embodiment of this application;
FIG. 9 is a schematic diagram of a multi-layer composite structure provided with a second fiber layer according to an embodiment of this application;
FIG. 10 is a schematic diagram of another multi-layer composite structure provided with a second fiber layer according to an embodiment of this application;
FIG. 11 is a schematic diagram of a multi-layer composite structure provided with a plurality of fiber layers according to an embodiment of this application;
FIG. 12 is a schematic diagram of another multi-layer composite structure provided with a plurality of fiber layers according to an embodiment of this application;
FIG. 13 is a schematic diagram of a preparation procedure for a multi-layer composite structure according to an embodiment of this application;
FIG. 14 is a schematic structural diagram of a battery cover according to an embodiment of this application; and
FIG. 15 is a schematic structural diagram of an electronic device according to an embodiment of this application.

### DESCRIPTION OF EMBODIMENTS

The following clearly describes technical solutions in embodiments of this application with reference to accompanying drawings in embodiments of this application. Apparently, the described embodiments are a part rather than all of the embodiments of this application. All other embodiments obtained by a person of ordinary skill in the art based on embodiments of this application without creative efforts shall fall within the protection scope of this application.

The terms "first" and "second" below are merely intended for a purpose of description, and shall not be understood as an indication or implication of relative importance or implicit indication of the quantity of indicated technical features. Therefore, a feature limited by "first" or "second" can explicitly or implicitly includes one or more features. In the description of this application, unless otherwise stated, "plurality of' means two or more than two.

In addition, in this application, orientation terms such as "upper" and "lower" are defined relative to orientations for schematic placement of components in the accompanying drawings. It should be understood that these directional terms are relative concepts, which are used for description and clarification relative to each other, and may change accordingly depending on changes in the orientations where the components are placed in the accompanying drawings.

The professional terms mentioned in embodiments of this application are explained below to facilitate the understanding of those skilled in the art.

PBO fiber is the abbreviation of poly-p-phenylene benzobisoxazole fiber (Poly-p-phenylene benzobisoxazole), which is a type of polyamide containing heterocyclic aromatic groups.

An appearance housing for a consumer electronic device such as a mobile phone, a tablet computer, or a PC mainly serves to decorate an appearance and protect use safety of a device such as a built-in battery of the electronic device and a processor. At present, there is an intense demand for overall weight and thickness reduction as well as high reliability in consumer electronic products, especially foldable devices. In the appearance housing, a battery cover is one of the primary scenarios targeted for thickness and weight reduction.

The foldable devices described in embodiments of this application include, but are not limited to, foldable fixed terminals or mobile terminals such as mobile phones, foldable screen mobile phones, notebook computers, foldable stands, foldable PADs, laptops, personal digital assistants, or wearable devices.

It should be understood that a foldable electronic device includes an inward-folding electronic device and an outward-folding electronic device. The inward-folding electronic device refers to an electronic device in which a flexible screen is located on the inner side of the device when the device is in a folded state. The outward-folding electronic device refers to an electronic device in which a flexible screen covers the outer side of the device when the device is in a folded state.

Under the current structural design of a battery cover for a foldable device, traditional glass fiber composite materials can no longer meet the design requirements for thickness and weight reduction. Furthermore, the battery cover made of glass fiber composite materials poses high reliability risks, particularly exhibiting poor puncture resistance of the battery cover in the event of device drops. The thickness and weight reduction conflicts with protection, resulting in poor effects of thickness reduction and weight reduction as well as poor puncture resistance.

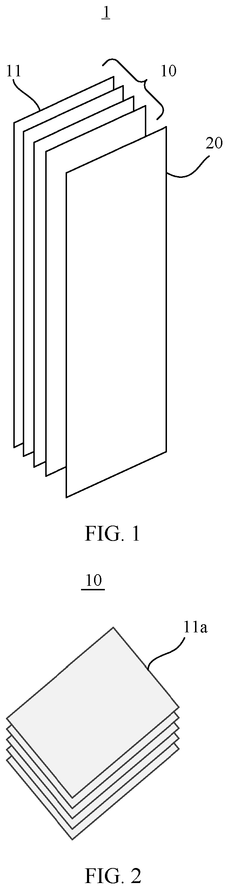

FIG. 1 is a schematic structural diagram of a battery cover. As shown in FIG. 1, a battery cover of a smart phone is used as an example. The battery cover 1 may include a substrate layer 10 and a decorative layer 20. The substrate layer 10 is formed by multi-layer stacking of prepregs 11 composed of a glass fiber, an aramid fiber or other fibers, while the decorative layer 20 may be made of ceramics, glass, leather, or other materials. This is not limited in this application. The decorative layer 20 is a structure disposed on a surface of the substrate layer 10 for appearance decoration, and the decorative layer 20 is thinner than the substrate layer 10. Therefore, in the process of reducing the thickness and weight of the battery cover 1, the substrate layer 10 is the main subject of structural design. Meanwhile, the substrate layer 10 is also an important component affecting a puncture resistance effect of the battery cover 1.

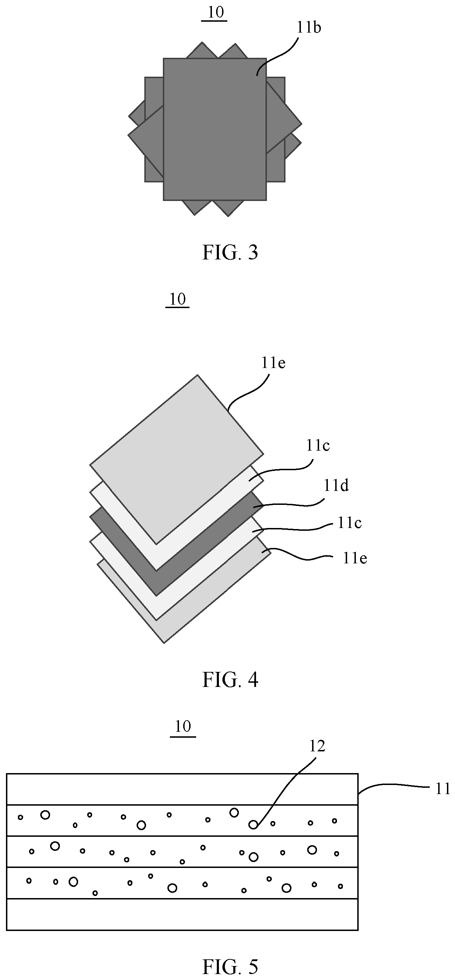

FIG. 2 is a schematic structural diagram of a substrate layer of a battery cover. FIG. 3 is a schematic structural diagram of another substrate layer of a battery cover. As shown in FIG. 2, the common substrate layer 10 is a structure formed by stacking E-glass fiber prepregs 11a with an E-glass fiber as the main component. The E-glass fiber is a glass fiber made of aluminoborosilicate glass, and the E-glass fiber in each E-glass fiber prepreg 11a is woven into a mesh structure to provide puncture resistance.

As shown in FIG. 3, in an embodiment, the glass fiber in the substrate layer 10 may be replaced with an S-glass fiber. To be specific, the substrate layer 10 is a structure formed by stacking S-glass fiber prepregs 11b with the S-glass fiber as the main component.

The S-glass fiber is an aluminosilicate-magnesia glass fiber. Compared with the E-glass fiber, the S-glass fiber has higher modulus and strength, and the S-glass fiber in the S-glass fiber prepreg 11b is also woven into a mesh structure. Moreover, during the stacking process, cross-stacking is adopted to enable the S-glass fibers in adjacent S-glass fiber prepregs 11b to be in different extension directions, thereby improving the impact resistance of the substrate layer 10. Meanwhile, a cross-stacking structure can reduce the generation of cracks in case of dropping, thereby achieving the effect of puncture resistance.

However, since the mechanical properties of the S-glass fiber are improved by approximately 20% compared with those of the E-glass fiber, the actual improvement in puncture resistance is limited. In addition, as both the S-glass fiber and the E-glass fiber are glass fibers, there is no significant difference in their densities. Therefore, the weights of the battery covers 1 composed of the substrate layers 10 using different glass fibers are basically the same, and the weights of the battery covers 1 cannot be optimized.

FIG. 4 is a schematic structural diagram of still another substrate layer of a battery cover. As shown in FIG. 4, in some embodiments, the substrate layer 10 may alternatively be fabricated by means of mixed stacking of a plurality of types of fiber prepregs. By way of example, the substrate layer 10 may be provided with five layers of prepregs 11, which may include a glass fiber prepreg 11c, a ceramic fiber prepreg 11d, and an aramid fiber prepreg 11e. The upper and lower sides of the ceramic fiber prepreg 11d are separately provided with a glass fiber prepreg 11c, while the side of each of the two glass fiber prepregs 11c away from the ceramic fiber prepreg 11d is provided with an aramid fiber prepreg 11e, thereby forming the substrate layer 10 with a five-layer structure.

By means of the mixed stacking of an aramid fiber and a ceramic fiber, the rigidity and toughness of the substrate layer 10 can be improved by virtue of the toughness of the aramid fiber and the high modulus of the ceramic fiber, thereby improving the impact resistance and puncture resistance of the substrate layer 10 and achieving the enhancement of the puncture resistance effect of the battery cover 1.

However, due to the high density of the ceramic fiber, the weight of the substrate layer 10 with the ceramic fiber will be increased, which affects the overall weight of the battery cover 1 and is not conducive to the weight reduction of the battery cover 1. In addition, although the ceramic fiber has high modulus, the ceramic fiber is relatively brittle compared with the glass fiber, resulting in limited improvement in puncture resistance.

FIG. 5 is a schematic structural diagram of still another substrate layer of a mobile phone cover. As shown in FIG. 5, in some embodiments, owing to high density of the glass fiber, hollow glass microspheres 12 may be added to the prepreg 11 of the substrate layer 10 to reduce the overall density of the prepreg 11 for the purpose of thickness and weight reduction.

Taking the substrate layer 10 including five layers of glass fiber prepregs as an example, hollow glass microspheres having a density of approximately 0.4 g/cm3 may be added to the glass fiber prepregs except the topmost and bottommost glass fiber prepregs, thereby reducing the density of the substrate layer 10 from approximately 1.9 g/cm3 to about 1.4 g/cm3, and achieving weight reduction of the battery cover 1.

It should be understood that to add hollow glass microspheres into the substrate layer 10, the hollow glass microspheres are required be added into resin for preparing the prepreg 11 during the preparation process of the prepreg 11. Moreover, to accommodate the glass microspheres, it is necessary to increase the resin content in the prepreg 11. However, since the strength of the resin is far inferior to that of fiber, the safety performance such as the puncture resistance of the substrate layer 10 will be reduced. Meanwhile, since the glass microspheres are relatively brittle in nature, the toughness of the substrate layer 10 will be reduced after addition, which is prone to edge chipping and similar defects during the manufacturing process, especially in operations such as cutting, thereby reducing the production yield of the battery cover 1.

To address the foregoing problems, embodiments of this application provide a multi-layer composite structure, a preparation method, a battery cover, and an electronic device. The thickness and weight reduction of the battery cover can be achieved, and the puncture resistance of the battery cover can be optimized, thereby reducing a risk of damage to internal components of the electronic device in scenarios such as dropping or other accidents, and improving the application safety of the electronic device.

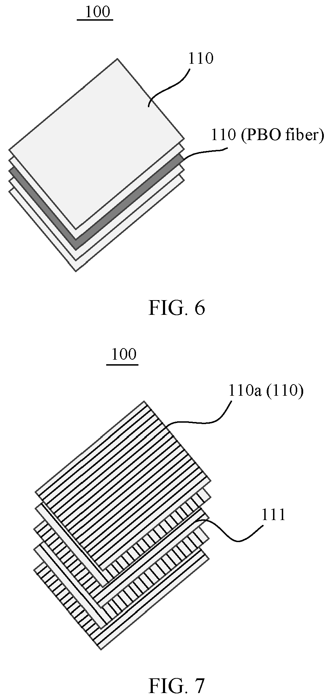

FIG. 6 is a schematic diagram of a multi-layer composite structure according to an embodiment of this application. As shown in FIG. 6, embodiments of this application provide a multi-layer composite structure 100. The multi-layer composite structure 100 includes a plurality of stacked fiber layers 110. Each fiber layer 110 is formed by impregnating a fiber sheet in a prepolymer solution followed by curing, where the fiber sheet in at least one fiber layer 110 is made of a PBO fiber.

In embodiments of this application, to cure the fiber sheets to form the fiber layers 110, it is necessary to control a mass proportion of the prepolymer solution in each fiber layer 110. Specifically, to enable the molding of the fiber layer 110 and subsequent operations such as hot pressing, the mass proportion of the prepolymer solution in the fiber layer 110 shall be greater than or equal to 30%.

However, compared with the fiber sheet, the prepolymer solution after curing has particular gaps in physical properties such as structural strength. Therefore, an excessive amount of prepolymer solution will reduce the structural strength of the formed fiber layer 110, which is not conducive to improving the puncture resistance of the multi-layer composite structure 100. Thus, the mass proportion of the prepolymer solution in the fiber layer 110 shall be less than or equal to 60%. To be specific, the mass proportion of the prepolymer solution in the fiber layer 110 shall be controlled within the range of 30% to 60%, so that the impact of the prepolymer solution on the strength of the fiber layer 110 is reduced while shaping the fiber layer 110, and the structural strength of the obtained multi-layer composite structure 100 is improved.

It should be understood that the mass proportion of the prepolymer solution in the fiber layer 110 refers to a mass proportion of a solid structure formed by curing the prepolymer solution in the cured fiber layer 110 in the cured fiber layer 110.

Meanwhile, to meet the structural design for thickness reduction and weight reduction, the thickness of each fiber layer 110 is greater than or equal to 0.03 mm and less than or equal to 0.3 mm, so that the fiber layer 110 has a small thickness while providing a particular level of structural strength, thereby facilitating the structural design of the battery cover with reduced thickness and weight by means of the multi-layer composite structure 100.

The PBO fiber has density, strength, and modulus close to those of a carbon fiber, as well as toughness comparable to that of an aramid fiber, and also has material properties such as light weight and high strength. Therefore, the fiber layer 110 made of the PBO fiber exhibits the foregoing advantages. The overall structural strength of the multi-layer composite structure 100 can be improved while reducing the weight, thereby further improving the structural strength and reducing the weight of the battery cover composed of the multi-layer composite structure 100, and achieving the thickness and weight reduction of the battery cover.

It should be noted that the prepolymer solution is mainly configured to shape and cure the fiber layers 110, and facilitates forming of the multi-layer composite structure 100 after stacking. In some embodiments, the prepolymer solution may include materials such as an epoxy monomer, a curing agent, an accelerator, a dispersant, and a filler. The specific types of materials contained in the prepolymer solution are not limited in this application.

By way of example, in the actual process of preparing the multi-layer composite structure 100, a plurality of fiber prepregs may be cut, stacked, and laminated to obtain the multi-layer composite structure 100, where at least one fiber prepreg is a PBO fiber prepreg. It should be understood that the fiber prepregs refer to the fiber layers 110 described in the foregoing embodiments.

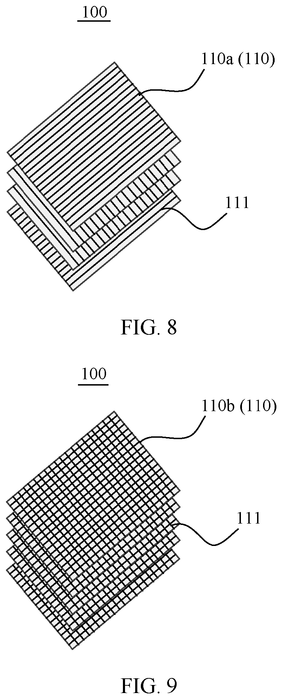

FIG. 7 is a schematic diagram of a multi-layer composite structure provided with a first fiber layer according to an embodiment of this application. FIG. 8 is a schematic diagram of another multi-layer composite structure provided with a first fiber layer according to an embodiment of this application.

In some embodiments of this application, the fiber in the fiber layer 110 may be in a unidirectional extension direction. As shown in FIG. 7 and FIG. 8, at least one fiber layer 110 among the plurality of fiber layers 110 is a first fiber layer 110a. The fiber sheet in each first fiber layer 110a is formed by arranging PBO fiber tows 111 in the same extension direction and under a straightened state.

By way of example, as shown in FIG. 7, the multi-layer composite structure 100 may include five fiber layers 110, and each fiber layer 110 is the first fiber layer 110a. The PBO fiber tows 111 in adjacent first fiber layers 110a are in different extension directions. Due to the different extension directions, the PBO fiber tows 111 in adjacent first fiber layers 110a form a cross structure, thereby improving the puncture resistance of the multi-layer composite structure 100.

Therefore, during the preparation of the multi-layer composite structure 100, a plurality of PBO fiber prepregs need to be cut, stacked, and laminated to obtain the multi-layer composite structure 100 where each fiber layer 110 is the first fiber layer 110a.

In some embodiments, an angle between the extension directions of the PBO fiber tows 111 in adjacent first fiber layers 110a is a right angle. As shown in FIG. 7, taking the extension direction of the PBO fiber tows 111 in the topmost first fiber layer 110a as 0°, the extension direction of the PBO fiber tows 111 in the first fiber layer 110a adjacent thereto may be 90°. The PBO fiber tows 111 in the five first fiber layers 110a may be arranged in the directional sequence of 0°/90°/0°/90°/0°, so as to improve the overall strength of the multi-layer composite structure 100.

As shown in FIG. 8, in some embodiments of this application, the multi-layer composite structure 100 may further include four fiber layers 110, and each fiber layer 110 is the first fiber layer 110a. The PBO fiber tows 111 in the topmost and bottommost first fiber layers 110a extend in a first direction. The PBO fiber tows 111 in the remaining first fiber layers 110a in the multi-layer composite structure 100 extend in a second direction, and the first direction is different from the second direction.

Compared with the multi-layer composite structure 100 in the foregoing embodiments, the multi-layer composite structure 100 in this embodiment has one fewer first fiber layer 110a, thereby further reducing the thickness and weight of the battery cover composed of the multi-layer composite structure 100. By way of example, the angle between the first direction and the second direction may alternatively be a right angle. Taking the first direction as 0° for example, the second direction may be 90°. Therefore, the PBO fiber tows 111 in the four first fiber layers 110a may be arranged in the directional sequence of 0°/90°/90°/0°, so as to improve the overall strength of the multi-layer composite structure 100.

It should be understood that the fiber density shown in FIG. 7 and FIG. 8 is merely an example for illustrating the arrangement mode of the PBO fiber tows.

In actual applications, the density of unidirectionally arranged fibers is relatively high, thereby reducing the mass of the prepolymer solution required for forming the first fiber layer 110a, and thus better retaining the inherent strength and modulus of the PBO fiber tows. Meanwhile, the PBO fiber tows in each first fiber layer 110a are under a straightened state, which enables better control over the thickness of the first fiber layer 110a, reduces surface unevenness of the first fiber layer 110a, and facilitates the thickness and weight reduction of the battery cover by means of the multi-layer composite structure 100.

In some embodiments of this application, the prepolymer solution contains resin for shaping the fiber layer 110. In the first fiber layer 110a, since the PBO fiber tows 111 in the same first fiber layer 110a are under a straightened state with high fiber density, the mass proportion of the prepolymer solution in the first fiber layer 110a is relatively low.

By way of example, the mass proportion of the prepolymer solution in each first fiber layer 110a ranges from 30% to 45%, thereby reducing the impact of the prepolymer solution on the strength of the first fiber layer 110a, better retaining the inherent strength and modulus of the PBO fiber tows 111, and improving the puncture resistance thereof. Meanwhile, the unidirectional and straightened PBO fiber tows 111 enable more precise control over the thickness of the first fiber layer 110a thus formed. By way of example, to ensure the strength of the multi-layer composite structure 100, the thickness of each first fiber layer 110a may be 0.1 mm.

It should be noted that the mass proportion of the prepolymer solution in the first fiber layer 110a and the thickness of the first fiber layer 110a are feasible implementations in this application, and the mass proportion of the prepolymer solution in the first fiber layer 110a and the thickness of the first fiber layer 110a may alternatively take other values. This application does not impose any limitation on the specific values of the mass proportion of resin and the thickness of the first fiber layer 110a.

By forming the first fiber layer 110a with the PBO fiber tows 111 extending in the same direction, the first fiber layer 110a may achieve higher single-layer strength and modulus compared with the glass fiber, thereby improving the puncture resistance of the battery cover composed of the multi-layer composite structure 100. The battery cover thus obtained can reduce the weight by 1 g to 1.5 g and improve the puncture resistance by 100% to 200% compared with the battery cover made of the glass fiber.

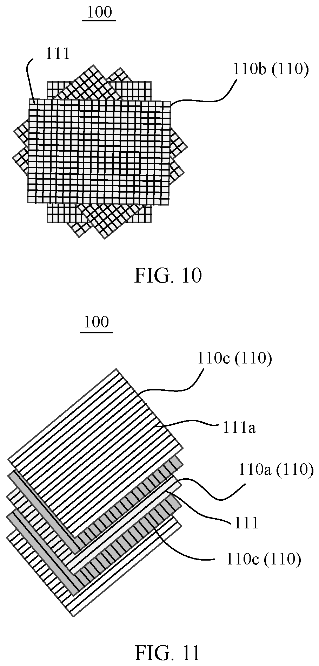

FIG. 9 is a schematic diagram of a multi-layer composite structure provided with a second fiber layer according to an embodiment of this application. FIG. 10 is a schematic diagram of another multi-layer composite structure provided with a second fiber layer according to an embodiment of this application.

In a feasible implementation of this application, at least one fiber layer 110 among the plurality of fiber layers 110 in the multi-layer composite structure 100 is a second fiber layer 110b. The fiber sheet in each second fiber layer 110b is formed by weaving PBO fiber tows 111 in which extension directions are a fifth direction and a sixth direction, and the fifth direction is different from the sixth direction.

As shown in FIG. 9 and FIG. 10, each fiber layer 110 in the multi-layer composite structure 100 is the second fiber layer 110b, and the multi-layer composite structure 100 may include four or five second fiber layers 110b. In some embodiments, an angle between the fifth direction and the sixth direction is a right angle. To be specific, the PBO fiber tows 111 in the second fiber layer 110b are disposed vertically.

The second fiber layer 110b may be directly stacked to form the multi-layer composite structure 100, or cross-stacked to improve the overall strength of the multi-layer composite structure 100. Specifically, as shown in FIG. 10, the multi-layer composite structure 100 includes four second fiber layers 110b. In the second fiber layer 110b, the PBO fiber tows 111 in the fifth direction serve as warp fibers, and the PBO fiber tows 111 in the sixth direction serve as weft fibers. Taking the warp fiber direction of the topmost second fiber layer 110b as 0° for example, the warp fibers of the four second fiber layers 110b from top to bottom may be arranged in the directional sequence of 0°/45°/90°/135°, thereby forming a cross-mesh structure and improving the overall strength of the multi-layer composite structure 100.

It should be noted that the weaving mode of the PBO fiber tows 111 shown in FIG. 9 and FIG. 10 is merely an example in this application. In actual practical applications, the weaving density of the PBO fiber tows 111 is higher, and gaps between the PBO fiber tows 111 are smaller. The second fiber layer 110b formed by weaving has the effect of preventing yarn loosening. However, since the weaving process will cause the crossed PBO fiber tows 111 to bend, the fiber sheet formed by weaving has a particular degree of unevenness. As a result, during the filling and curing process of the prepolymer solution, the weight of the prepolymer solution will increase to some extent. In addition, the thickness of the second fiber layer 110b is limited by the thickness of at least two crossed PBO fiber tows 111. Compared with the first fiber layer 110a, the reduction in thickness and weight of the multi-layer composite structure 100 constructed by using the second fiber layer 110b is limited.

In some embodiments, the prepolymer solution for forming the second fiber layer 110b also contains resin. Moreover, due to the characteristics of woven fibers, the mass proportion of the prepolymer solution in the second fiber layer 110b is higher than the mass proportion in the first fiber layer 110a. By way of example, a mass proportion of the prepolymer solution in each second fiber layer 110b is 45% to 55%, and each second fiber layer 110b has a thickness ranging from 0.1 mm to 0.2 mm.

The PBO fiber tows 111 are woven to form the second fiber layer 110b, so that the second fiber layer 110b may achieve higher single-layer strength and modulus compared with the glass fiber, thereby improving the puncture resistance of the battery cover composed of the multi-layer composite structure 100. The battery cover thus obtained can reduce the weight by 0.5 g to 1 g and improve the puncture resistance by 50% to 80% compared with the battery cover made of the glass fiber.

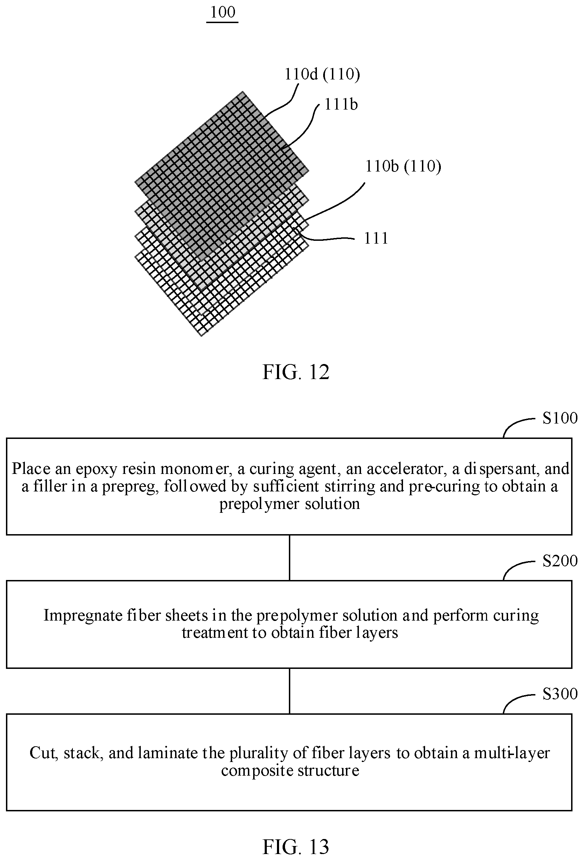

FIG. 11 is a schematic diagram of a multi-layer composite structure provided with a plurality of fiber layers according to an embodiment of this application. FIG. 12 is a schematic diagram of another multi-layer composite structure provided with a plurality of fiber layers according to an embodiment of this application. Owing to high cost of the PBO fibers and relatively poor compatibility of the PBO fibers with the resin in the prepolymer solution compared with fibers such as the glass fiber, a third fiber layer 110c may be disposed in the multi-layer composite structure 100 as shown in FIG. 11, so as to improve the strength of the multi-layer composite structure 100 and reduce the weight thereof to achieve weight and thickness reduction in some embodiments.

Specifically, among the plurality of fiber layers 110 in the multi-layer composite structure 100, the remaining fiber layers 110 other than at least one first fiber layer 110a are third fiber layers 110c. The fiber sheet in the third fiber layer 110c is formed by arranging first fiber tows 111a in the same extension direction and under a straightened state, and the first fiber tows 111a may be any one fiber selected from a glass fiber, an aramid fiber, a ceramic fiber, and a carbon fiber.

In the multi-layer composite structure 100, the plurality of third fiber layers 110c may be stacked, and at least one first fiber layer 110a is disposed between adjacent third fiber layers 110c. As shown in FIG. 11, the multi-layer composite structure 100 includes five fiber layers 110, where a first fiber layer 110a and four third fiber layers 110c are disposed. In this case, the four third fiber layers 110c may be stacked, and the first fiber layer 110a is disposed at a middle position of the multi-layer composite structure 100. To be specific, two third fiber layers 110c exist above and below the first fiber layer 110a.

It should be noted that the fiber types used in different third fiber layers 110c may be the same or may be different. As shown in FIG. 11, the first fiber layer 110a is disposed at the middle position of the multi-layer composite structure 100. The first fiber tows 111a in the two third fiber layers 110c on the upper and lower sides of the first fiber layer 110a may be aramid fibers, and the first fiber tows 111a in the topmost and bottommost third fiber layers 110c in the multi-layer composite structure 100 may be glass fibers or carbon fibers.

It should be understood that the material of the first fiber tows 111a in the third fiber layers 110c and the arrangement of the third fiber layers 110c are only one feasible implementation. This application may further include third fiber layers 110c with other materials and arrangement modes. Therefore, the material of the first fiber tows 111a and the stacking arrangement mode of the third fiber layers 110c are not limited in this application.

In some embodiments, to improve the puncture resistance of the multi-layer composite structure 100, the PBO fiber tows 111 in the first fiber layers 110a may extend in a third direction. The first fiber tows 111a in the third fiber layer 110c adjacent to the first fiber layer 110a may extend in a fourth direction. The third direction is different from the fourth direction, and the first fiber tows 111a in adjacent third fiber layers 110c are in different extension directions. By way of example, an angle between the third direction and the fourth direction may be a right angle.

In this way, the fibers in different fiber layers 110 may be arranged in a crossed pattern, thereby reducing the gaps in the multi-layer composite structure 100 and improving the strength of the multi-layer composite structure 100.

It should be understood that in the process of constructing the multi-layer composite structure 100 with a plurality of fibers, the strength of the multi-layer composite structure 100 can also be improved by means of fiber weaving. As shown in FIG. 12, the fiber layer 110 in the multi-layer composite structure 100 may include at least one second fiber layer 110b and a plurality of fourth fiber layers 110d.

By way of example, among the plurality of fiber layers 110 in the multi-layer composite structure 100, the remaining fiber layers 110 other than at least one second fiber layer 110b are fourth fiber layers 110d. The fiber sheet in the fourth fiber layer 110d is formed by weaving second fiber tows 111b in which extension directions are the fifth direction and the sixth direction, and the second fiber tows 111b may be any one fiber selected from a glass fiber, an aramid fiber, a ceramic fiber, and a carbon fiber.

In the multi-layer composite structure 100, the plurality of fourth fiber layers 110d may be stacked, and at least one second fiber layer 110b is disposed between adjacent fourth fiber layers 110d. As shown in FIG. 12, the multi-layer composite structure 100 includes four fiber layers 110, where a second fiber layer 110b and three fourth fiber layers 110d are disposed. In this case, the three fourth fiber layers 110d may be stacked, and the second fiber layer 110b is disposed between two adjacent fourth fiber layers 110d. To be specific, one fourth fiber layer 110d exists on one side of the second fiber layer 110b, and two fourth fiber layers 110d exist on the other side.

It should be understood that the fiber types used in different fourth fiber layers 110d may be the same or may be different. By way of example, as shown in FIG. 12, the second fiber tows 111b in the three fourth fiber layers 110d may be glass fibers, aramid fibers, and carbon fibers respectively, or alternatively be glass fibers, aramid fibers, and ceramic fibers. The type of the second fiber tows 111b in the fourth fiber layer 110d is not limited in this application.

FIG. 13 is a schematic diagram of a preparation procedure for a multi-layer composite structure according to an embodiment of this application.

This application further provides a preparation method for a multi-layer composite structure while providing the multi-layer composite structure 100. As shown in FIG. 13, the preparation method includes:

S100: Place an epoxy resin monomer, a curing agent, an accelerator, a dispersant, and a filler in a prepreg, followed by sufficient stirring and pre-curing to obtain a prepolymer solution.

The epoxy resin monomer may be bisphenol A epoxy resin. The curing agent may be an amine-based curing agent. The accelerator may be a polyamide resin accelerator. The dispersant may be a surfactant-based dispersant. The filler may be talcum powder. The prepolymer solution may be formed by fully stirring the foregoing reaction solution and then performing pre-curing.

By way of example, the epoxy resin monomer may be of a grade 618 epoxy resin monomer, and a heating temperature during the pre-curing process may be 70°C. It should be understood that the type of the foregoing epoxy resin monomer and the pre-curing temperature are only one feasible implementation. This application may alternatively adopt other types of epoxy resin monomers and pre-curing temperatures to achieve the foregoing effects.

S200: Impregnate fiber sheets in the prepolymer solution and perform curing treatment to obtain fiber layers.

After the prepolymer solution is obtained, the fiber sheets may be impregnated in the prepolymer solution for curing treatment, to obtain the fiber layers. It should be noted that in the actual production process, a product obtained by impregnating the fiber sheet in the prepolymer solution and performing curing treatment is a fiber prepreg. The fiber prepreg is an intermediate product for manufacturing a fiber composite structure. For example, a PBO fiber prepreg may be obtained by impregnating a PBO fiber sheet in the prepolymer solution and performing curing treatment. In embodiments of this application, one fiber layer 110 may be regarded as one fiber prepreg, and the operations performed on a plurality of fiber layers 110 in the subsequent steps may be regarded as operations on a plurality of fiber prepregs.

It can be seen from the foregoing embodiments of the multi-layer composite structure 100 that the fiber sheet in the fiber layer 110 may be either a unidirectionally arranged fiber sheet or a woven fiber sheet formed by weaving fibers. Therefore, the preparation process of the fiber layer 110 may include preparation using the unidirectionally arranged fiber sheet and preparation using the woven fiber sheet.

By way of example, to prepare the fiber layer 110 with the unidirectionally arranged fiber sheet, a fiber package yarn may first be positioned, and fiber tows may be unidirectionally arranged through yarn swinging to form a plurality of fiber sheets. The fiber tows in at least one fiber sheet are PBO fiber tows. It should be understood that in the fiber layer 110 according to embodiments of this application, a single type of fiber tow is used. To be specific, each fiber layer 110 contains a fiber sheet formed by one and only one type of fiber tow.

The plurality of obtained fiber sheets are impregnated in the prepolymer solution respectively. Meanwhile, to reduce the impact of the prepolymer solution on the strength of the formed fiber layer 110 and the thickness of the subsequently formed multi-layer composite structure, it is necessary to control the mass proportion of the prepolymer solution in the plurality of impregnated fiber sheets as well as the thickness of the plurality of impregnated fiber sheets, so as to realize the control of the prepared product.

After the completion of impregnation, since the prepolymer solution has high fluidity, it is also necessary to cure the plurality of impregnated fiber sheets respectively to obtain the plurality of fiber layers.

As for preparing the fiber layer 110 using woven fiber sheets, a plurality of woven fiber sheets may be prepared by weaving fiber tows, where the fiber tows in at least one woven fiber sheet are PBO fiber tows.

The plurality of obtained woven fiber sheets are impregnated in the prepolymer solution respectively, and a mass proportion of the prepolymer solution in the plurality of impregnated woven fiber sheets as well as a thickness of the plurality of impregnated woven fiber sheets are controlled. Finally, the plurality of impregnated woven fiber sheets are cured respectively to obtain the plurality of fiber layers.

Specifically, the plurality of impregnated fiber sheets may be cured by means of oven heating, with the curing temperature ranging from 100°C to 120°C.

It should be understood that compared with the unidirectionally arranged fiber sheet, the fiber tows in the woven fiber sheet have a particular degree of bending, and the gaps formed by the woven structure will result in a higher mass proportion of the prepolymer solution in the impregnated woven fiber sheet and a greater thickness of the impregnated woven fiber sheet than those of the unidirectionally arranged fiber sheet.

In embodiments of this application, the fiber sheet in the fiber layer 110 may have a grammage ranging from 30 g/m2 to 140 g/m2. It should be understood that the arrangement mode of the fiber tows affects the grammage of the fiber layer 110. The grammage range of the unidirectionally arranged fiber sheet may be 30 g/m2 to 140 g/m2, while the grammage range of the woven fiber sheet may be 50 g/m2 to 140 g/m2. By way of example, taking the fiber sheet composed of PBO fiber tows as an example, a fiber sheet having a grammage of 50 g/m2 or a woven fiber sheet having a grammage of 60 g/m2 may be preferably used for preparing the fiber layer 110.

Meanwhile, to facilitate the molding of the fiber layer 110 and reduce the impact of the prepolymer solution on the strength of the fiber layer 110, the mass proportion of the prepolymer solution in the fiber layer 110 is 30% to 60%, and the thickness of the fiber layer 110 is 0.03 mm to 0.3 mm. Preferably, in the fiber layer 110 prepared from a unidirectionally arranged fiber sheet, the mass proportion of the prepolymer solution in each fiber layer 110 is 30% to 45%, and each fiber layer 110 has a thickness of 0.04 mm to 0.2 mm. In the fiber layer 110 prepared from a woven fiber sheet, the mass proportion of the prepolymer solution in each fiber layer 110 is 45% to 55%, and each fiber layer 110 has a thickness of 0.1 mm to 0.2 mm. It should be noted that the specific thickness of the fiber layer 110 may be adjusted as required.

S300: Cut, stack, and laminate the plurality of fiber layers to obtain a multi-layer composite structure.

The fiber sheet in at least one fiber layer is made of a PBO fiber. The multi-layer composite structure 100 obtained by processing the plurality of fiber layers 110 is a composite material. In actual applications, to facilitate subsequent operations, it is necessary to control the size of the formed multi-layer composite structure 100 during the preparation process of the multi-layer composite structure 100. For example, when preparing a mobile phone cover using the multi-layer composite structure 100, a rectangular multi-layer composite structure 100 with both length and width slightly larger than those of the mobile phone is required. Therefore, the shape and size of the multi-layer composite structure 100 are related to a preset preparation target. Therefore, when preparing the multi-layer composite structure 100, it is necessary to cut the plurality of fiber layers 110 separately to obtain fiber layers of a preset size, where the preset size is associated with a structure to be prepared from the multi-layer composite structure 100.

Then, the plurality of cut fiber layers 110 are stacked, where the fiber tows in adjacent fiber layers 110 are in different extension directions. Further, an angle between the extension directions of the fiber tows in adjacent fiber layers 110 may be a right angle. Alternatively, the fiber tows in the topmost and bottommost fiber layers 110 extend in a first direction. The fiber tows in the remaining fiber layers other than the topmost layer and the bottommost layer extend in a second direction. The first direction is different from the second direction. If the first direction is 0°, the second direction may be any value such as 45°, 60°, 90°, or other angles. In some embodiments, to achieve a regular arrangement and improve the overall strength of the formed multi-layer composite structure 100, the second direction may be 90° when the first direction is 0°. Finally, the plurality of stacked fiber layers 110 may be laminated to obtain the multi-layer composite structure 100.

In some embodiments, if the fiber sheet in the fiber layer 110 is a woven fiber sheet, during the preparation process of the multi-layer composite structure 100, the plurality of fiber layers 110 may be first cut respectively to obtain a plurality of fiber layers 110 of a preset size. Then, the plurality of cut fiber layers 110 are stacked. Finally, the plurality of stacked fiber layers 110 are laminated to obtain the multi-layer composite structure 100. The stacking mode of the plurality of fiber layers 110 may be as shown in FIG. 10, which will not be repeated in this application.

The cutting may adopt laser cutting. The lamination may include hot pressing. A hot pressing temperature ranges from 100°C to 200°C, a hot pressing time is 10 min to 30 min, and a hot pressing pressure is 0.2 MPa to 0.7 MPa.

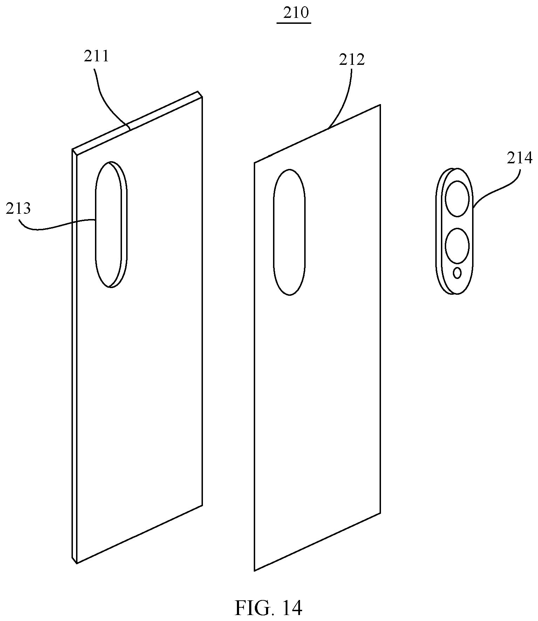

FIG. 14 is a schematic structural diagram of a battery cover according to an embodiment of this application.

While this application provides a multi-layer composite structure 100 and a preparation method for the multi-layer composite structure 100, embodiments of this application further provide a battery cover 210. As shown in FIG. 14, the battery cover 210 includes a substrate layer 211 and a decorative layer 212. The substrate layer 211 includes the multi-layer composite structure 100 according to any one of the foregoing embodiments. The decorative layer 212 is disposed on a side of the substrate layer 211. The decorative layer 212 may be made of glass, ceramics, resin, or other materials with decorative functions. The material of the decorative layer 212 is not limited in this application.

In some embodiments, to meet the device mounting requirements of some electronic devices, through holes 213 are provided on the substrate layer 211 and the decorative layer 212. The battery cover 210 further includes a camera lens 214. The shape of the camera lens 214 is matched with that of the through hole 213, and the camera lens 214 covers the through hole 213. To realize the photographing function of the electronic device, the camera lens 214 may be made of glass or other transparent materials. This is not limited in this application.

It should be understood that the camera lens 214 is disposed on the side of the battery cover 210 provided with the decorative layer 212, to provide a particular degree of protection for the components inside the electronic device.

The preparation process of the battery cover 210 is illustrated below through several embodiments.

### Embodiment 1

(1) Since the substrate layer 211 is exactly the multi-layer composite structure 100 according to any of the foregoing embodiments, the preparation process of the substrate layer 211 is the same as that of the foregoing multi-layer composite structure 100. By way of example, the preparation of the substrate layer 211 may include:
   A grade 618 epoxy resin monomer, an amine-based curing agent, a polyamide resin accelerator, a surfactant-based dispersant, and talcum powder are placed into a prepreg, stirred thoroughly, heated to 70°C, and pre-cured to form a prepolymer solution, where the ratio of the epoxy resin monomer to the amine-based curing agent, the polyamide resin accelerator, the surfactant-based dispersant, and the talcum powder is 100:10:20:10:18.

PBO fiber package yarns are positioned, and fiber tows are arranged into a unidirectional PBO fiber sheet with uniform thickness and width via yarn swinging.

The unidirectional PBO fiber sheets are impregnated with the prepolymer solution through a prepreg production line, and then hot rollers are used to control a mass proportion of the prepolymer solution in the unidirectional PBO fiber sheet at 40% and the thickness of the impregnated unidirectional PBO fiber sheet at 0.05 mm, to obtain a unidirectional PBO fiber sheet impregnated with the prepolymer solution.

The unidirectional PBO fiber sheet impregnated with the prepolymer solution is placed into an oven for curing at a temperature ranging from 100°C to 120°C, to obtain a unidirectional PBO fiber prepreg.

Laser cutting is performed on the unidirectional PBO fiber prepreg to obtain unidirectional PBO fiber prepreg sheets, where the laser cutting directions are a fiber direction of the unidirectional PBO fiber prepreg and a direction perpendicular to the fiber direction respectively, i.e., 0° and 90°.

According to design for a 0.4 mm-thick battery cover substrate layer, unidirectional PBO fiber prepreg sheets are stacked in 4 layers according to a sequence of 0°/90°/90°/0° and hot pressed, where hot pressing parameters include 150°C/20 min, and pressure of 0.5 Mpa, and a PBO fiber composite sheet with a non-molding edge is obtained after cooling as the substrate layer 211.

### (2) Preparation of the entire battery cover 210

Appearance treatment is performed on the obtained substrate layer 211 to facilitate the mounting of the decorative layer 212 on the surface of the substrate layer 211. The mounting modes for the decorative layer 212 include spraying, pad printing, or lamination of PU leather, etc. Then, laser profile cutting is performed on the substrate layer 211, a non-molding surface is removed, and the through hole 213 is formed according to the design of the camera lens 214, so as to obtain a main structure of the battery cover 210.

Auxiliary materials are attached to the obtained main structure of the battery cover 210, and the camera lens 214 is assembled to obtain the final battery cover 210.

Compared with a 0.4 mm-thick battery cover made of pure woven E-grade glass fiber, the battery cover 210 prepared in this embodiment reduces the overall weight of the device by 1.5 g and improves the puncture resistance by 100%.

### Embodiment 2

Embodiment 2 provides a battery cover 210. The differences between Embodiment 2 and Embodiment 1 lie in the mass proportion of the prepolymer solution in the unidirectional PBO fiber sheets, the thickness of the impregnated unidirectional PBO fiber sheets, the directional sequence of stacking the unidirectional PBO fiber prepreg sheets, as well as the number of layers. In this embodiment, the mass proportion of the prepolymer solution in the unidirectional PBO fiber sheets is 45%, the thickness of the impregnated unidirectional PBO fiber sheets is controlled at 0.1 mm, and the unidirectional PBO fiber prepreg sheets are stacked in 5 layers according to a directional sequence of 0°/90°/0°/90°/0°.

Compared with a 0.4 mm-thick battery cover made of pure woven E-grade glass fiber, the battery cover 210 prepared in this embodiment reduces the overall weight of the device by 1 g and improves the puncture resistance by 200%.

### Embodiment 3

Embodiment 3 provides a battery cover 210. The differences between Embodiment 3 and Embodiment 1 lie in that, according to the design for a 0.4 mm-thick battery cover substrate, unidirectional PBO fiber prepreg sheets are stacked with other unidirectional fiber prepreg sheets, where one or more layers in the middle are the unidirectional PBO fiber prepreg sheets. In this embodiment, unidirectional glass fiber prepreg sheets, unidirectional aramid fiber prepreg sheets, unidirectional PBO fiber prepreg sheets, and unidirectional ceramic fiber prepreg sheets are stacked in 4 layers according to a sequence of 0°/90°/90°/0° and hot pressed, where hot pressing parameters include 150°C/20 min, and pressure of 0.5 Mpa, and a composite laminated sheet with a non-molding edge is obtained after cooling as the substrate layer 211.

Compared with a 0.4 mm-thick battery cover made of pure woven E-grade glass fiber, the battery cover 210 prepared in this embodiment reduces the overall weight of the device by 0.5 g and improves the puncture resistance by 120%.

### Embodiment 4

Embodiment 4 provides a battery cover 210. The differences between Embodiment 4 and Embodiment 1 lie in that, according to the design for a 0.4 mm-thick battery cover substrate, unidirectional PBO fiber prepreg sheets are stacked with other unidirectional fiber prepreg sheets, where one or more layers in the middle are the unidirectional PBO fiber prepreg sheets. In this embodiment, unidirectional glass fiber prepreg sheets, unidirectional PBO fiber prepreg sheets, unidirectional PBO fiber prepreg sheets, and unidirectional carbon fiber prepreg sheets are stacked in 4 layers according to a sequence of 0°/90°/90°/0° and hot pressed, where hot pressing parameters include 150°C/20 min, and pressure of 0.5 Mpa, and a composite laminated sheet with a non-molding edge is obtained after cooling as the substrate layer 211.

Compared with a 0.4 mm-thick battery cover made of pure woven E-grade glass fiber, the battery cover 210 prepared in this embodiment reduces the overall weight of the device by 1 g and improves the puncture resistance by 80%.

### Embodiment 5

Embodiment 5 provides a battery cover 210. The differences between Embodiment 5 and Embodiment 2 lie in that, according to the design for a 0.4 mm-thick battery cover substrate, unidirectional PBO fiber prepreg sheets are stacked with other unidirectional fiber prepreg sheets, where one or more layers in the middle are the unidirectional PBO fiber prepreg sheets. In this embodiment, unidirectional aramid fiber prepreg sheets, unidirectional glass fiber prepreg sheets, unidirectional PBO fiber prepreg sheets, unidirectional carbon fiber prepreg sheets, and unidirectional ceramic fiber prepreg sheets are stacked in 5 layers according to a sequence of 0°/90°/0°/90°/0° and hot pressed, where hot pressing parameters include 150°C/20 min, and pressure of 0.5 Mpa, and a composite laminated sheet with a non-molding edge is obtained after cooling as the substrate layer 211.

Compared with a 0.4 mm-thick battery cover made of pure woven E-grade glass fiber, the battery cover 210 prepared in this embodiment reduces the overall weight of the device by 0.6 g and improves the puncture resistance by 100%.

### Embodiment 6

Embodiment 6 provides a battery cover 210. The differences between Embodiment 6 and Embodiment 2 lie in that, according to the design for a 0.4 mm-thick battery cover substrate, unidirectional PBO fiber prepreg sheets are stacked with other unidirectional fiber prepreg sheets, where one or more layers in the middle are the unidirectional PBO fiber prepreg sheets. In this embodiment, unidirectional aramid fiber prepreg sheets, unidirectional PBO fiber prepreg sheets, unidirectional PBO fiber prepreg sheets, unidirectional PBO fiber prepreg sheets, and unidirectional ceramic fiber prepreg sheets are stacked in 5 layers according to a sequence of 0°/90°/0°/90°/0° and hot pressed, where hot pressing parameters include 150°C/20 min, and pressure of 0.5 Mpa, and a composite laminated sheet with a non-molding edge is obtained after cooling as the substrate layer 211.

Compared with a 0.4 mm-thick battery cover made of pure woven E-grade glass fiber, the battery cover 210 prepared in this embodiment reduces the overall weight of the device by 0.8 g and improves the puncture resistance by 120%.

### Embodiment 7

### (1) Production of the substrate layer 211

A grade 618 epoxy resin monomer, an amine-based curing agent, a polyamide resin accelerator, a surfactant-based dispersant, and talcum powder are placed into a prepreg, stirred thoroughly, heated to 70°C, and pre-cured to form a prepolymer solution, where the ratio of the epoxy resin monomer to the amine-based curing agent, the polyamide resin accelerator, the surfactant-based dispersant, and the talcum powder is 100: 10:20:10:18.

The woven PBO fiber sheets are impregnated with the prepolymer solution through a prepreg production line, and then hot rollers are used to control a mass proportion of the prepolymer solution in the woven PBO fiber sheet at 50% and the thickness of the impregnated woven PBO fiber sheet at 0.1 mm, to obtain a woven PBO fiber sheet impregnated with the prepolymer solution.

The woven PBO fiber sheet impregnated with the prepolymer solution is placed into an oven for curing at a temperature ranging from 100°C to 120°C, to obtain a woven PBO fiber prepreg.

Laser cutting is performed on the woven PBO fiber prepreg to obtain woven PBO fiber prepreg sheets, where the laser cutting directions are warp directions at 0°, 45°, 90°, and 135° respectively.

According to design for a 0.4 mm-thick battery cover substrate, woven PBO fiber prepreg sheets are stacked in 4 layers according to a sequence of 0°/45°/90°/135° and hot pressed, where hot pressing parameters include 150°C/20 min, and pressure of 0.5 Mpa, and a PBO fiber composite sheet with a non-molding edge is obtained after cooling as the substrate layer 211.

### (2) Preparation of the entire battery cover 210

Appearance treatment is performed on the obtained substrate layer 211 to facilitate the mounting of the decorative layer 212 on the surface of the substrate layer 211. The mounting modes for the decorative layer 212 include spraying, pad printing, or lamination of PU leather, etc. Then, laser profile cutting is performed on the substrate layer 211, a non-molding surface is removed, and the through hole 213 is formed according to the design of the camera lens 214, so as to obtain a main structure of the battery cover 210.

Auxiliary materials are attached to the obtained main structure of the battery cover 210, and the camera lens 214 is assembled to obtain the final battery cover 210.

Compared with a 0.4 mm-thick battery cover made of pure woven E-grade glass fiber, the battery cover 210 prepared in this embodiment reduces the overall weight of the device by 1 g and improves the puncture resistance by 50%.

### Embodiment 8

Embodiment 8 provides a battery cover 210. The differences between Embodiment 8 and Embodiment 7 lie in the mass proportion of the prepolymer solution in the woven PBO fiber sheets, the thickness of the impregnated woven PBO fiber sheets, the directional sequence of stacking the woven PBO fiber prepreg sheets, as well as the number of layers. In this embodiment, the mass proportion of the prepolymer solution in the woven PBO fiber sheets is 55%, the thickness of the impregnated woven PBO fiber sheets is controlled at 0.2 mm, and the woven PBO fiber prepreg sheets are stacked in 5 layers according to a directional sequence of 0°/45°/90°/135°/0°.

Compared with a 0.4 mm-thick battery cover made of pure woven E-grade glass fiber, the battery cover 210 prepared in this embodiment reduces the overall weight of the device by 0.5 g and improves the puncture resistance by 80%.

### Embodiment 9

Embodiment 9 provides a battery cover 210. The differences between Embodiment 9 and Embodiment 7 lie in that, according to the design for a 0.4 mm-thick battery cover substrate, woven PBO fiber prepreg sheets are stacked with other woven fiber prepreg sheets, where one or more layers in the middle are the woven PBO fiber prepreg sheets. In this embodiment, woven aramid fiber prepreg sheets, woven PBO fiber prepreg sheets, woven ceramic fiber prepreg sheets, and woven carbon fiber prepreg sheets are stacked in 4 layers according to a sequence of 0°/45°/90°/135° and hot pressed, where hot pressing parameters include 150°C/20 min, and pressure of 0.5 Mpa, and a composite laminated sheet with a non-molding edge is obtained after cooling as the substrate layer 211.

Compared with a 0.4 mm-thick battery cover made of pure woven E-grade glass fiber, the battery cover 210 prepared in this embodiment reduces the overall weight of the device by 0.8 g and improves the puncture resistance by 100%.

### Embodiment 10

Embodiment 10 provides a battery cover 210. The differences between Embodiment 10 and Embodiment 7 lie in that, according to the design for a 0.4 mm-thick battery cover substrate, woven PBO fiber prepreg sheets are stacked with other woven fiber prepreg sheets, where one or more layers in the middle are the woven PBO fiber prepreg sheets. In this embodiment, woven aramid fiber prepreg sheets, woven PBO fiber prepreg sheets, woven PBO fiber prepreg sheets, and woven ceramic fiber prepreg sheets are stacked in 4 layers according to a sequence of 0°/45°/90°/135° and hot pressed, where hot pressing parameters include 150°C/20 min, and pressure of 0.5 Mpa, and a composite laminated sheet with a non-molding edge is obtained after cooling as the substrate layer 211.

Compared with a 0.4 mm-thick battery cover made of pure woven E-grade glass fiber, the battery cover 210 prepared in this embodiment reduces the overall weight of the device by 0.8 g and improves the puncture resistance by 100%.

### Embodiment 11

Embodiment 11 provides a battery cover 210. The differences between Embodiment 10 and Embodiment 8 lie in that, according to the design for a 0.4 mm-thick battery cover substrate, woven PBO fiber prepreg sheets are stacked with other woven fiber prepreg sheets, where one or more layers in the middle are the woven PBO fiber prepreg sheets. In this embodiment, woven carbon fiber prepreg sheets, woven ceramic fiber prepreg sheets, woven PBO fiber prepreg sheets, woven aramid fiber prepreg sheets, and woven glass fiber prepreg sheets are stacked in 5 layers according to a sequence of 0°/45°/90°/135°/0° and hot pressed, where hot pressing parameters include 150°C/20 min, and pressure of 0.5 Mpa, and a composite laminated sheet with a non-molding edge is obtained after cooling as the substrate layer 211.

Compared with a 0.4 mm-thick battery cover made of pure woven E-grade glass fiber, the battery cover 210 prepared in this embodiment reduces the overall weight of the device by 0.5 g and improves the puncture resistance by 120%.

### Embodiment 12

Embodiment 12 provides a battery cover 210. The differences between Embodiment 12 and Embodiment 8 lie in that, according to the design for a 0.4 mm-thick battery cover substrate, woven PBO fiber prepreg sheets are stacked with other woven fiber prepreg sheets, where one or more layers in the middle are the woven PBO fiber prepreg sheets. In this embodiment, woven ceramic fiber prepreg sheets, woven PBO fiber prepreg sheets, woven PBO fiber prepreg sheets, woven PBO fiber prepreg sheets, and woven aramid fiber prepreg sheets are stacked in 5 layers according to a sequence of 0°/45°/90°/135°/0° and hot pressed, where hot pressing parameters include 150°C/20 min, and pressure of 0.5 Mpa, and a composite laminated sheet with a non-molding edge is obtained after cooling as the substrate layer.

Compared with a 0.4 mm-thick battery cover made of pure woven E-grade glass fiber, the battery cover 210 prepared in this embodiment reduces the overall weight of the device by 0.5 g and improves the puncture resistance by 120%.

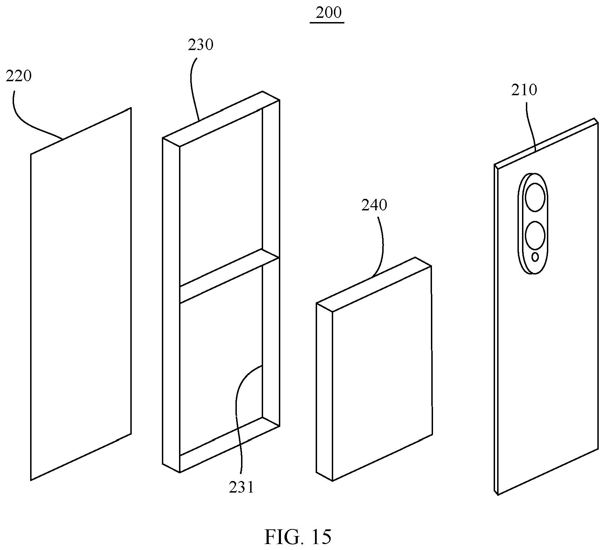

FIG. 15 is a schematic structural diagram of an electronic device according to an embodiment of this application.

While this application provides a multi-layer composite structure 100 and a battery cover 210, embodiments of this application further provide an electronic device 200. As shown in FIG. 15, the electronic device 200 may include a front panel 220, a middle frame 230, a battery 240, and a battery cover 210. The middle frame 230 is disposed on a side of the front panel 220, and a battery compartment 231 is provided inside the middle frame 230. After the electronic device 200 is fully mounted, the battery 240 is located in the battery compartment 231. The battery cover 210 is disposed on a side of the middle frame 230 away from the front panel 220. The battery cover 210 can be configured to protect the battery 240 disposed in the battery compartment 231.

In embodiments of this application, a cavity enclosed by the front panel 220, the middle frame 230, and the battery cover 210 further contains electronic components. The electronic components include, but are not limited to, a processor, an antenna, a sensor, a gyroscope, a speaker, and other devices, so as to enable the normal operation of the electronic device 200.

It should be noted that after considering the specification and practicing the present disclosure, a person skilled in the art may easily conceive of other implementations of this application. This application is intended to cover any variations, uses, or adaptive changes of this application. These variations, uses, or adaptive changes follow the general principles of this application and include common general knowledge or common technical means in the art, which are not disclosed in this application. The specification and the embodiments are considered as merely exemplary, and the scope and spirit of this application are pointed out in the following claims.

It should be understood that this application is not limited to the precise structures described above and shown in the accompanying drawings, and various modifications and changes can be made without departing from the scope of this application. The scope of this application is subject only to the appended claims.

## Claims

1. A multi-layer composite structure, comprising:
a plurality of stacked fiber layers, wherein each fiber layer is formed by impregnating a fiber sheet in a prepolymer solution followed by curing; and
the fiber sheet in at least one fiber layer is made of a poly-p-phenylene benzobisoxazole PBO fiber.

2. The multi-layer composite structure according to claim 1, wherein
at least one fiber layer among the plurality of fiber layers is a first fiber layer; and
the fiber sheet in each first fiber layer is formed by arranging PBO fiber tows in the same extension direction and under a straightened state.

3. The multi-layer composite structure according to claim 2, wherein
each fiber layer among the plurality of fiber layers is the first fiber layer; and
the PBO fiber tows in adjacent first fiber layers are in different extension directions.

4. The multi-layer composite structure according to claim 3, wherein
an angle between the extension directions of the PBO fiber tows in adjacent first fiber layers is a right angle.

5. The multi-layer composite structure according to claim 2, wherein
each fiber layer among the plurality of fiber layers is the first fiber layer;
the PBO fiber tows in the topmost and bottommost first fiber layers in the multi-layer composite structure extend in a first direction;
the PBO fiber tows in the remaining first fiber layers in the multi-layer composite structure extend in a second direction; and
the first direction is different from the second direction.

6. The multi-layer composite structure according to claim 5, wherein
an angle between the first direction and the second direction is a right angle.

7. The multi-layer composite structure according to any one of claims 2 to 6, wherein
a mass proportion of the prepolymer solution in each first fiber layer is 30% to 45%; and
each first fiber layer has a thickness of 0.04 mm to 0.2 mm.

8. The multi-layer composite structure according to claim 2, wherein
the remaining fiber layers other than the first fiber layers in the plurality of fiber layers are third fiber layers;
the fiber sheet in the third fiber layer is formed by arranging first fiber tows in the same extension direction and under a straightened state, and the first fiber tows are any one fiber selected from a glass fiber, an aramid fiber, a ceramic fiber, and a carbon fiber; and
the plurality of third fiber layers are stacked, and at least one first fiber layer is disposed between adjacent third fiber layers.

9. The multi-layer composite structure according to claim 8, wherein
the PBO fiber tows in the first fiber layers extend in a third direction;
the first fiber tows in the third fiber layer adjacent to the first fiber layer extend in a fourth direction;
the first fiber tows in adjacent third fiber layers are in different extension directions; and
the third direction is different from the fourth direction.

10. The multi-layer composite structure according to claim 9, wherein
an angle between the third direction and the fourth direction is a right angle.

11. The multi-layer composite structure according to claim 1, wherein
at least one fiber layer among the plurality of fiber layers is a second fiber layer; and
the fiber sheet in each second fiber layer is formed by weaving PBO fiber tows in which extension directions are a fifth direction and a sixth direction, and the fifth direction is different from the sixth direction.

12. The multi-layer composite structure according to claim 11, wherein
each fiber layer among the plurality of fiber layers is the second fiber layer; and
an angle between the fifth direction and the sixth direction is a right angle.

13. The multi-layer composite structure according to claim 11 or 12, wherein
a mass proportion of the prepolymer solution in each second fiber layer is 45% to 55%; and
each second fiber layer has a thickness of 0.1 mm to 0.2 mm.

14. The multi-layer composite structure according to claim 11, wherein
the remaining fiber layers other than the second fiber layers in the plurality of fiber layers are fourth fiber layers;
the fiber sheet in the fourth fiber layer is formed by weaving second fiber tows in which extension directions are the fifth direction and the sixth direction, and the second fiber tows are any one fiber selected from a glass fiber, an aramid fiber, a ceramic fiber, and a carbon fiber; and
the plurality of fourth fiber layers are stacked, and at least one second fiber layer is disposed between adjacent fourth fiber layers.

15. The multi-layer composite structure according to any one of claims 1 to 14, wherein
a mass proportion of the prepolymer solution in each fiber layer is 30% to 60%; and
each fiber layer has a thickness of greater than or equal to 0.03 mm and less than or equal to 0.3 mm.

16. A preparation method for a multi-layer composite structure, comprising:
placing an epoxy resin monomer, a curing agent, an accelerator, a dispersant, and a filler in a prepreg, followed by sufficient stirring and pre-curing to obtain a prepolymer solution;
impregnating fiber sheets in the prepolymer solution and performing curing treatment to obtain fiber layers; and
cutting, stacking, and laminating the plurality of fiber layers to obtain a multi-layer composite structure, wherein the fiber sheet in at least one fiber layer is made of a PBO fiber.

17. The preparation method for a multi-layer composite structure according to claim 16, wherein
the impregnating fiber sheets in the prepolymer solution and performing curing treatment to obtain fiber layers comprises:
positioning fiber package yarns, and unidirectionally arranging fiber tows by means of yarn swinging to prepare the plurality of fiber sheets, wherein the fiber tows in at least one fiber sheet are PBO fiber tows;
impregnating the plurality of fiber sheets in the prepolymer solution respectively;
controlling a mass proportion of the prepolymer solution in the plurality of impregnated fiber sheets, as well as a thickness of the plurality of impregnated fiber sheets; and
curing the plurality of impregnated fiber sheets respectively to obtain the plurality of fiber layers.

18. The preparation method for a multi-layer composite structure according to claim 17, wherein
the cutting, stacking, and laminating the plurality of fiber layers to obtain a multi-layer composite structure comprises:
cutting the plurality of fiber layers respectively to obtain a plurality of fiber layers of a preset size;
stacking the plurality of cut fiber layers, wherein fiber tows in adjacent fiber layers are in different extension directions, or the fiber tows in the topmost and bottommost fiber layers extend in a first direction, the fiber tows in the remaining fiber layers other than the topmost layer and the bottommost layer extend in a second direction, and the first direction is different from the second direction; and
laminating the plurality of stacked fiber layers to obtain the multi-layer composite structure.

19. The preparation method for a multi-layer composite structure according to claim 17 or 18, wherein
a mass proportion of the prepolymer solution in each fiber layer is 30% to 45%; and
each fiber layer has a thickness of 0.04 mm to 0.2 mm.

20. The preparation method for a multi-layer composite structure according to claim 16, wherein
the impregnating fiber sheets in the prepolymer solution and performing curing treatment to obtain fiber layers comprises:
preparing a plurality of woven fiber sheets by weaving fiber tows, wherein the fiber tows in at least one woven fiber sheet are PBO fiber tows;
impregnating the plurality of woven fiber sheets in the prepolymer solution respectively;
controlling a mass proportion of the prepolymer solution in the plurality of impregnated woven fiber sheets, as well as a thickness of the plurality of impregnated woven fiber sheets; and
curing the plurality of impregnated woven fiber sheets respectively to obtain the plurality of fiber layers.

21. The preparation method for a multi-layer composite structure according to claim 20, wherein
the cutting, stacking, and laminating the plurality of fiber layers to obtain a multi-layer composite structure comprises:
cutting the plurality of fiber layers respectively to obtain a plurality of fiber layers of a preset size;
stacking the plurality of cut fiber layers; and
laminating the plurality of stacked fiber layers to obtain the multi-layer composite structure.

22. The preparation method for a multi-layer composite structure according to claim 20 or 21, wherein
a mass proportion of the prepolymer solution in each fiber layer is 45% to 55%; and
each fiber layer has a thickness of 0.1 mm to 0.2 mm.

23. The preparation method for a multi-layer composite structure according to any one of claims 17 to 22, wherein
the fiber sheet has a grammage of 30 g/m2 to 140 g/m2.

24. The preparation method for a multi-layer composite structure according to claim 16, wherein
the lamination comprises hot pressing, a hot pressing temperature is 100°C to 200°C, a hot pressing time is 10 min to 30 min, and a hot pressing pressure is 0.2 MPa to 0.7 MPa.

25. The preparation method for a multi-layer composite structure according to claim 16, wherein
a mass proportion of the prepolymer solution in the fiber layer is 30% to 60%, and the fiber layer has a thickness of 0.03 mm to 0.3 mm.

26. A battery cover, comprising:
a substrate layer, wherein the substrate layer comprises the multi-layer composite structure according to any one of claims 1 to 15;
a decorative layer, wherein the decorative layer is disposed on a side of the substrate layer, and a through hole is provided on the substrate layer and the decorative layer; and
a camera lens, wherein the camera lens covers the through hole, and the camera lens is disposed on a side of the battery cover provided with the decorative layer.

27. An electronic device, comprising:
a front panel;
a middle frame, wherein the middle frame is disposed on a side of the front panel, and a battery compartment is disposed in the middle frame;
a battery, wherein the battery is disposed in the battery compartment; and
the battery cover according to claim 26, wherein the battery cover is disposed on a side of the middle frame away from the front panel, and the battery cover is configured to protect the battery disposed in the battery compartment.
